Europäisches Patentamt

European Patent Office

Office européen des brevets

(11) Veröffentlichungsnummer: **0 188 842**
**A2**

# (12) EUROPÄISCHE PATENTANMELDUNG

(21) Anmeldenummer: 85202084.1

(22) Anmeldetag: 16.12.85

(51) Int. Cl.⁴: **H 03 G 3/20**

(30) Priorität: 25.01.85 DE 3502422

(43) Veröffentlichungstag der Anmeldung: 30.07.86
Patentblatt 86/31

(84) Benannte Vertragsstaaten: **AT BE DE FR GB**

(71) Anmelder: **Philips Patentverwaltung GmbH, Billstrasse 80, D-2000 Hamburg 28 (DE)**

(84) Benannte Vertragsstaaten: **DE**

(71) Anmelder: **N.V. Philips' Gloeilampenfabrieken, Groenewoudseweg 1, NL-5621 BA Eindhoven (NL)**

(84) Benannte Vertragsstaaten: **BE FR GB AT**

(72) Erfinder: **Kupfer, Karl-Heinz, Krefelder Strasse 145, D-4150 Krefeld 29 (DE)**

(74) Vertreter: **Kupfermann, Fritz-Joachim et al, Philips Patentverwaltung GmbH Billstrasse 80 Postfach 10 51 49, D-2000 Hamburg 28 (DE)**

(54) Schaltungsanordnung zur automatischen Verstärkungsregelung.

(57) Die Erfindung betrifft eine Schaltungsanordnung zur automatischen Verstärkungsregelung, vorzugsweise bei Magnetaufnahme- und/oder Wiedergabegeräten, die einen ersten und einen zweiten Eingang (1, 3) aufweist. Der Ausgang (5) der automatischen Verstärkungsregelung wird bei Ansprechen derselben niederohmiger und regelt so das dem ersten und zweiten Eingang (1, 3) zugeführte Signal im Pegel, wobei der Ausgang (5) bei einem Ansprechen in Folge dem ersten Eingang (1) zugeführter Signale mit einer kleineren Einregelzeitkonstante niederohmiger wird als bei einem Ansprechen in Folge dem zweiten Eingang (2) zugeführter Signale. Dem ersten Eingang (1) wird ein Tonsignal ohne Höhen-Preemphasis und dem zweiten Eingang (3) das gleiche, jedoch mit Höhen-Preemphasis versehene Tonsignal zugeführt.

ACTORUM AG

0188842

Schaltungsanordnung zur automatischen Verstärkungsregelung

Die Erfindung bezieht sich auf eine Schaltungsanordnung zur automatischen Verstärkungsregelung, vorzugsweise bei Magnet-Aufnahme- und/oder Wiedergabegeräten, die auf einen mehrstufigen Verstärkerzweig arbeitet, mit einem ersten und einem zweiten Eingang und einem Ausgang, der bei einem Ansprechen der Schaltungsanordnung niederohmiger wird und so dem ersten und zweiten Eingang zugeführte Signale im Pegel regelt und der bei einem Ansprechen in Folge dem ersten Eingang zugeführter Signale mit einer kleineren Einregelzeitkonstante niederohmiger wird als bei einem Ansprechen in Folge dem zweiten Eingang zugeführter Signale.

In der Nachrichtentechnik ist es häufig erforderlich, Tonsignale, z. B. menschliche Sprache oder Musik, auf einen bestimmten maximalen Pegel zu regeln. Dieser Vorgang wird meist als Aussteuern bezeichnet. Insbesondere im Bereich der Unterhaltungselektronik ist es, meist aus Bequemlichkeitsgründen, wünschenwert, diese Aussteuerung automatisch vorzunehmen, d. h. ohne Zutun des Bedienenden. Schaltungen zur automatischen Aussteuerung befinden sich in fast allen Videorecordern und in vielen Kompakt-Kassettenrecordern. Die Grundproblematik der Regelungen für automatische Aussteuerungen liegt darin, daß zum einen eine Übersteuerung des Bandes verhindert werden soll, zum anderen aber keine zu heftige Reaktion auf einzelne Impulse erfolgen darf.

Aus der DE-OS 30 27 715 ist eine Schaltungsanordnung zur selbsttätigen Regelung oder Begrenzung der Dynamik bekannt, bei der auf eine schnelle Reaktion der Regelung besonderer Wert gelegt wird.

Die Schaltungsanordnung weist zwei Eingänge auf, die je einen Kondensator aufladen. Die Zeitkonstanten sind so gewählt, daß sowohl die Auf- wie auch die Entladezeitkonstante des ersten Kondensators sehr klein sind und die des zweiten Kondensators deutlich größer sind. Dies führt jedoch, insbesondere in Verbindung mit einer Spitzenwert- Gleichrichtung des Signals, zu einer Überreaktion bei kurzzeitigen Hochfrequenzsignalkomponenten. Dies bedeutet, daß die Regelung bei kurzzeitigen Hochfrequenzsignalkomponenten das Tonsignal stark herunterregelt, anschließend jedoch zu langsam wieder heraufregelt, was sich akustisch störend bemerkbar macht. Dieses sogenannte "Flattern" ergibt insgesamt ein sehr unruhiges Klangbild. Beim Vorhandensein von Rauschunterdrückungsschaltungen wird dies meist noch verstärkt.

Weiterhin ist aus der DE-OS 23 01 281 eine Schaltung zur automatischen Verstärkungsregelung bekannt, die versucht, dieses Problem dadurch zu umgehen, daß sie mit zwei Regeleingängen mit verschiedenen Ansprechzeiten und verschieden Erholungszeiten arbeitet. So soll z. B. bei einem Impuls oder Geräusch kurzer Dauer nur eine kurze Erholungszeit vorgesehen sein. Gerade dieses führt jedoch zu dem oben erwähnten Flattern und unruhigem Klangbild, insbesondere wenn die Regelung in einem Aufsprechverstärker so angeordnet ist, daß sie das bereits mit Preemphasis versehene Tonsignal erhält. Ist sie jedoch so im Aufnahmeverstärkerzweig angeordnet, daß sie das Signal ohne Höhenanhebung

0188842

erhält, tritt der Effekt ein, daß die Höhen übersteuert werden, da sie durch die Regelung nicht stärker bewertet werden als die Mitten und Bässe. Damit bleibt unberücksichtigt, daß die Höhen nach der Verstärkungsregelung angehoben werden.

Es ist Aufgabe der Erfindung, eine Schaltung zur automatischen Verstärkungsregelung zu schaffen, die in der Lage ist, ein Tonsignal auf einen bestimmten Pegel auszusteuern, und zwar unter Berücksichtigung der Preemphasis, und die nicht zu heftig auf einzelne Hochtonimpulse reagiert.

Diese Aufgabe wird erfindungsgemäß dadurch gelöst, daß ein Ausgang eines frequenzlinear arbeitenden Verstärkers mit dem ersten Eingang der Schaltungsanordnung verbunden ist und ein Eingang dieses Verstärkers mit dem Ausgang der Schaltungsanordnung verbunden ist und daß ein Eingang eines weiteren Verstärkers, der mit einem RC-Netzwerk zur Pegelanhebung der höherfrequenten Signalanteile verschaltet ist, mit dem Ausgang des erstgenannten Verstärkers verbunden ist und ein Ausgang des weiteren Verstärkers mit dem zweiten Eingang der Schaltungsanordnung verbunden ist.

Diese Schaltung zur automatischen Verstärkungsregelung besitzt einen ersten Eingang mit einer kleinen Einregelzeit, an dem das lineare Tonsignal anliegt und der den Hauptteil der automatischen Regelung vornimmt. Da das Signal hier noch keine Höhenanhebung aufweist, wird auch keine zu starke Reaktion auf Hochtonimpulse erfolgen. Das Klangbild wird also insgesamt kein hörbares Regeln aufweisen. Um nun die Höhenanhebung zu berücksichtigen, weist die Schaltung einen zweiten Eingang auf mit einer größeren Einregelzeitkonstante, dessen Eingang das bereits mit Preemphasis versehene Tonsignal erhält. Auf diese Weise werden durch die automatische Verstärkungseregelung die Höhen in dem Tonsignal berücksichtigt, einschließlich ihrer Anhebung, jedoch ohne Reaktion der Verstärkungsregelung auf einzelne kurze Hochtonimpulse. Dies führt zu einem insgesamt wesentlich ruhigeren und ausgeglicheneren Klangbild.

Die Tatsache, daß an den ersten, mit kleinerer Einregelzeitkonstante versehenen Eingang das Tonsignal ohne Höhenanhebung gelegt wird, ermöglicht es, die Einregelzeitkonstante weiter zu verkleinern und zusätzlich auch die Ausregelzeitkonstante zu verkleinern, ohne daß bei einzelnen Hochtonimpulsen die Gefahr besteht, daß die Verstärkungsregelung zu stark mit Abregeln reagiert.

Nach einer weiteren Ausgestaltung der Erfindung ist vorgesehen, daß das dem zweiten Eingang zugeführte Tonsignal zusätzlich den Aufnahme- oder Wiedergabeteil eines Rauschunterdrückungssystems passiert.

Fast alle üblichen Rauschunterdrückungssysteme heben im Aufnahmeteil die Höhen nochmals an, und zwar um bis zu etwa 20 dB. Die oben beschriebenen Vorteile der Schaltungsanordnung zur automatischen Verstärkungsregelung nach der Erfindung kommen hier in besonderer Weise zum Tragen, da auch bei dieser Konstellation dennoch ein ruhiges Regelverhalten, auch bei kurzen Hochtonimpulsen, die beispielsweise um 30 dB im Pegel angehoben sind, gewährleistet ist.

0188842

Ausführungsbeispiele nach der Erfindung werden anhand der Zeichnungen näher erläutert. Es zeigen:

Fig. 1 eine Schaltungsanordnung zur automatischen Verstärkungsregelung nach der ersten Ausführungsform der Erfindung,

Fig. 2 eine Schaltungsanordnung zur automatischen Verstärkungsregelung nach der zweiten Ausführungsform der Erfindung.

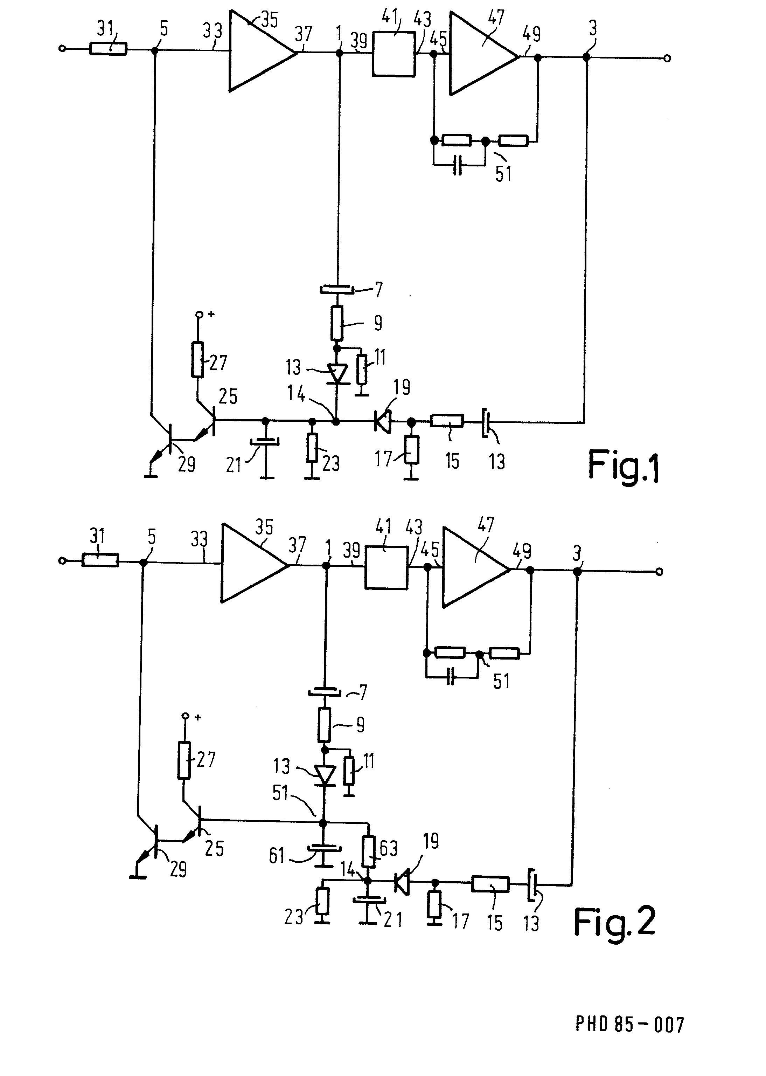

In Fig. 1 ist unten dargestellt eine Schaltungsanordnung zur automatischen Verstärkungsregelung mit einem ersten Eingang 1, einem zweiten Eingang 3 und einem Ausgang 5. Am ersten Eingang 1 liegen in Reihe ein Kondensator 7, ein Widerstand 9 und ein weiterer Widerstand 11, der gegen Masse geschaltet ist. Vom Verbindungspunkt der Widerstände 9 und 10 führt eine Diode 13 zu einem Sternpunkt 14, mit dem sie mit ihrer Kathode verbunden ist. Der zweite Eingang 3 weist ebenfalls in Reihe verschaltet einen Kondensator 13, einen ersten Widerstand 15 und einen zweiten, mit Masse verbunden Widerstand 17 auf. Der Verbindungspunkt zwischen den beiden Widerständen ist in gleicher Weise über eine Diode mit dem Sternpunkt 14 verbunden. Ferner ist der Sternpunkt 14 verbunden mit einem Kondensator 21, einem Widerstand 23, die beide gegen Masse geschaltet sind, und der Basis eines Transistors 25, dessen Kollektor über einen Widerstand 27 mit der Stromversorgung verbunden ist und dessen Emitter mit der Basis eines weiteren Transistors 29 verschaltet ist, der mit seiner Basis an Masse liegt und dessen Kollektor den Ausgang 5 bildet.

Die Schaltungsanordnung zur automatischen Verstärkungsregelung kann beispielsweise wie folgt mit einem Aufnahmeverstärker verbunden sein. Das aufzunehmende Tonsignal ist
über einen Widerstand 31 sowohl mit dem Ausgang 5 der Verstärkungsregelungsschaltung, wie auch mit einem Eingang
eines ersten Verstärkers 35 verbunden. Dessen Ausgang 37
ist sowohl mit dem ersten Eingang 1 der Verstärkungsregelungsschaltung, wie auch mit dem Eingang 39 einer
Rauschunterdrückungsschaltung 41 verbunden. Der Ausgang 43
dieser Schaltung führt auf den Eingang 45 eines zweiten
Verstärkers 47, dessen Ausgang 49 über ein RC-Netzwerk 51
zur Preemphasis (Höhenanhebung) des Tonsignals an seinen
Eingang 45 rückgekoppelt ist. Ferner ist der Ausgang 49
des zweiten Verstärkers 47 mit dem zweiten Eingang 3 der
Verstärkungsregelungsschaltung verbunden. Dieser Ausgang
49 der zweiten Verstärkerstufe liefert also das durch die
automatische Verstärkungsregelung auf einen bestimmten
Pegel geregelte Signal, das außerdem mit Preemphasis versehen ist und evtl. auch den Aufnahmeteil einer Rauschunterdrückungsschaltung durchlaufen hat.

Die Einregelzeitkonstante des ersten Einganges wird
bestimmt durch die Werte der Kondensatoren 7 und 21 und
des Widerstandes 9, die des zweiten Eingangs durch die
Werte der Kondensatoren 13 und 21 und des Widerstandes
15. Die Dioden 13 und 19 dienen der Gleichrichtung. Da
sowohl die Signale des ersten Eingangs 1 als auch die des
zweiten Eingangs 3 beide den Kondensator 21 aufladen, ist
also auch die Ausregelzeitkonstante beider Eingänge
identisch. Die Ausregelzeitkonstante wird bestimmt durch
den Wert des Kondensators 21 und des Widerstandes 23. Ist
der Kondensator 21 auf einen solchen Wert aufgeladen, daß
an der Basis des Transistors 25 dessen Schwellspannung

überschritten wird, so werden Transistor 25 und 29 leitend. Diese Ausgangswiderstandsänderung von Transistor 29 regelt das über den Widerstand 31 am Eingang 33 des Verstärkers 35 liegende Tonsignal.

Das in Fig. 2 dargestellte Ausführungsbeispiel nach der zweiten Ausgestaltung der Erfindung weist ebenfalls zwei Eingänge 1 und 3 auf, deren Eingangsschaltungen, bestehend aus jeweils einem Kondensator, zwei Widerständen und einer Diode, genauso verschaltet sind wie im in Fig. 1 dargestellten Ausführungsbeispiel nach der ersten Ausgestaltung der Erfindung. Die Kathode der Diode 13 des ersten Einganges 1 führt auf einen Sternpunkt 51. Von diesem Sternpunkt 51 führt zum einen ein Kondensator 61 gegen Masse, zum anderen ist der Sternpunkt über einen Widerstand 63 mit dem Sternpunkt 14 verbunden, der, ebenso wie in dem Ausführungsbeispiel in Fig. 1, über einen Widerstand 23 und einen Kondensator 21 gegen Masse verschaltet ist. Der Sternpunkt 51 ist ferner verbunden mit der Basis des Transistors 25, der ansonsten, ebenso wie der Transistor 29, verschaltet ist, wie im in Fig. 1 dargestellten Ausführungsbeispiel. In diesem Ausführungsbeispiel nach der zweiten Ausgestaltung der Erfindung laden also am Eingang 3 der Schaltungsanordnung anliegende Signale lediglich den Kondensator 21 auf. Am Eingang 1 anliegende Signale laden jedoch sowohl den Kondensator 61, über den Widerstand 63 jedoch auch den Kondensator 21 auf. Die Zeitkonstanten sind dabei so gewählt, daß der Kondensator 61 wesentlich schneller aufgeladen und entladen wird als der Kondensator 21. Dies bedeutet also, daß die Verstärkungsregelung entsprechend der Zeitkonstanten, mit der der Kondensator 21 verschaltet ist, langsam reagiert und damit hörbare Regelvorgänge nahezu ausschließt. Dennoch können

0188842

vereinzelt auftauchende Impulse schnell ausgeregelt werden, da diese den Kondensator 61 schnell aufladen. Mit häufiger werdendem Aufladen des Kondensators 61 wird über den Widerstand 63 auch der Kondensator 21 aufgeladen und so die Verstärkung langsam dem neuen Pegelniveau angepaßt.

Insgesamt ergibt die Schaltungsanordnung zur automatischen Verstärkerungsregelung nach der Erfindung in beiden Ausführungsformen durch ihre Art der Regelung ein sehr ruhiges Klangbild mit gleichwohl kurzen Einregelzeiten und ist für Geräte mit zusätzlichen Rauschunterdrückungsschaltungen von besonderem Vorteil.

Die in den Fig. 1 und 2 dargestellten Ausführungsbeispiele beziehen sich auf den Aufnahmeteil eines Magnetbandgerätes. Für den Wiedergabeteil ist die Schaltungsanordnung identisch, das Wiedergabesignal wird jedoch dann nicht mehr am Eingang 3 der Schaltungsanordnung, sondern am Eingang 45 des Verstärkers 47 abgenommen, da in diesem Falle die durch das Netzwerk 51 vorgenommene Höhenanhebung nicht erwünscht ist. Ist bei aufnahme- und wiedergabeseitig symmetrisch arbeitenden Rauschunterdrückungssystemen entsprechend den Fig. 1 und 2 der Aufnahmeteil 41 einer solchen Rauschunterdrückung entsprechend den Fig. 1 und 2 vorgesehen, so ist für korrektes Arbeiten der Rauschunterdrückungsschaltung wiedergabeseitig die gleiche Verstärkungsregelungsschaltung vorgesehen, die auch die gleichen Zeitkonstanten wie die aufnahmeseitige Schaltung aufweisen sollte. Der Wiedergabeteil der Rauschunterdrückungsschaltung ist genauso verschaltet wie der Aufnahmeteil. Das Wiedergabesignal wird dann dem Ausgang der Rauschunterdrückungsschaltung entnommen.

PATENTANSPRÜCHE

1. Schaltungsanordnung zur automatischen Verstärkungsregelung, vorzugsweise bei Magnet-Aufnahe- und/oder Wiedergabegeräten, die auf einen mehrstufigen Verstärkerzweig arbeitet, mit einem ersten (1) und einem zweiten Eingang (3) und einem Ausgang (5), der bei einem Ansprechen der Schaltungsanordnung niederohmiger wird und so dem ersten (1) und zweiten Eingang (3) zugeführte Signale im Pegel regelt und der bei einem Ansprechen in Folge dem ersten Eingang (1) zugeführter Signale mit einer kleineren Einregelzeitkonstante niederohmiger wird als bei einem Ansprechen in Folge dem zweiten Eingang (3) zugeführter Signale, dadurch gekennzeichnet, daß ein Ausgang (37) eines frequenzlinear arbeitenden Verstärkers (35) mit dem ersten Eingang (1) der Schaltungsanordnung verbunden ist und ein Eingang (33) dieses Verstärkers (35) mit dem Ausgang (5) der Schaltungsanordnung verbunden ist und daß ein Eingang (45) eines weiteren Verstärkers (47), der mit einem RC-Netzwerk (51) zur Pegelanhebung der höherfrequenten Signalanteile verschaltet ist, mit dem Ausgang (37) des erstgenannten Verstärkers (35) verbunden ist und ein Ausgang (49) des weiteren Verstärkers (47) mit dem zweiten Eingang (3) der Schaltungsanordnung verbunden ist.

2. Schaltungsanordnung nach Anspruch 1, dadurch gekennzeichnet, daß der Ausgang (5) der Schaltungsanordnung nach einem Ansprechen mit einer Ausregelzeitkonstante wieder hochohmiger wird, deren Größe unabhängig davon ist, welcher der Eingänge (1, 3) das Ansprechen ausgelöst hat.

3. Schaltungsanordnung nach Anspruch 2, dadurch gekennzeichnet, daß die Signale des ersten (1) und des zweiten Eingangs (3) in der Schaltungsanordnung einen gemeinsamen Ladekondensator (21) aufladen, dessen Spannung den Innenwiderstand des Ausgangs (5) steuert.

4. Schaltungsanordnung nach Anspruch 1, dadurch gekennzeichnet, daß die Signale des ersten Eingangs (1) einen ersten Ladekondensator (61) und einen zweiten Ladekondensator (21) aufladen und die Signale des zweiten Eingangs (3) nur den zweiten Ladekondensator (21) aufladen, daß die Entladezeitkonstante des ersten Kondensators (61) kleiner ist als die des zweiten (21) und daß die Spannung der Parallelschaltung des ersten Kondensators (61) und der Reihenschaltung des zweiten Kondensators (21) und eines Widerstandes (63) den Innenwiderstand des Ausgangs (5) steuert.

5. Schaltungsanordnung nach einem oder mehreren der Ansprüche 1 bis 4, dadurch gekennzeichnet, daß das dem zweiten Eingang (3) zugeführte Signal den Aufnahme- oder Wiedergabeteil eines Rauschunterdrückungssystems passiert.

Fig.1

Fig.2

0188842